# FASCICULE DE BREVET EUROPEEN

(11) **EP 3 749 075 B1**
(45) Date de publication et mention de la délivrance du brevet: **14.06.2023**
(21) Numéro de dépôt: 20175576.6
(22) Date de dépôt: 20.05.2020
(51) Int. Cl.: H05K 7/20

(54) **CIRCUIT DE REFROIDISSEMENT ACTIF POUR EQUIPEMENT ELECTRIQUE**
AKTIVER KÜHLKREISLAUF FÜR ELEKTROGERÄT
ACTIVE COOLING CIRCUIT FOR ELECTRICAL EQUIPMENT

(30) Priorité: 06.06.2019 FR 1905993
(43) Date de publication de la demande: 09.12.2020
(73) Titulaire: Valeo eAutomotive France SAS, 95800 Cergy (FR)
(72) Inventeur: DOUILLARD, Sébastien, 95290 L'ISLE ADAM (FR); LAMARCHE, Anthony, 78450 VILLEPREUX (FR)
(74) Mandataire: Valeo Powertrain Systems

(56) Documents cités:
- WO-A1-2016/195570
- US-A1- 2019 045 661
- US-B2- 7 578 337

## Description

### DOMAINE TECHNIQUE DE L'INVENTION

La présente invention se rapporte au domaine du refroidissement actif de composants électroniques d'équipements électriques. En particulier, l'invention se rapporte à un circuit de refroidissement dans lequel est destiné à circuler un fluide de refroidissement, dans un équipement électrique.

Plus précisément, l'invention vise, dans un équipement électrique, en particulier de type chargeur électrique, comprenant un circuit de refroidissement tortueux, notamment « tridimensionnel », à empêcher le fluide de refroidissement de s'immiscer dans un jeu fonctionnel, c'est-à-dire un interstice existant entre deux portions complémentaires constitutives dudit circuit de refroidissement dudit équipement électrique.

### ETAT DE LA TECHNIQUE

Dans un équipement électrique, tel qu'un convertisseur continu-continu ou un chargeur électrique embarqué (OBC pour « On-Board Charger » en anglais), il est connu qu'un circuit de refroidissement soit intégré au châssis de l'équipement, pour assurer un refroidissement actif de composants de l'équipement électrique, notamment par circulation d'un fluide de refroidissement, par exemple un liquide de refroidissement tel que de l'eau ou du glycol.

Notamment, un tel circuit de refroidissement peut être formé à partir de deux parties complémentaires. Dans ce cas, par exemple, un châssis et un couvercle d'un équipement électrique comprennent des portions de circuit de refroidissement complémentaires. Lesdites portions complémentaires comprennent des canaux, des parties creuses ou des protubérances, de sorte que le circuit de refroidissement obtenu par assemblage peut notamment s'étendre de manière « tridimensionnelle », en ce sens que le chemin suivi par le fluide de refroidissement subit des changements de direction dans trois directions non coplanaires. Autrement dit, le canal de circulation comprend alors des paliers successifs à des niveaux différents.

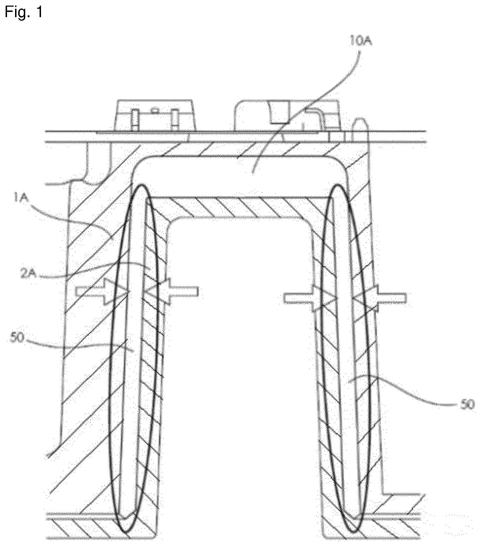

Dans ce cas, en particulier, les parties complémentaires, qui comprennent les portions complémentaires du circuit de refroidissement, sont conçues de telle sorte qu'il existe un jeu fonctionnel permettant le montage et l'imbrication desdites parties complémentaires l'une dans l'autre. Ce jeu fonctionnel 50 est représenté sur la figure 1, qui montre une section d'un canal de circulation comportant des portions complémentaires imbriquées. Le fluide de refroidissement est supposé cheminer dans le canal 10A mais une partie s'immisce dans le jeu fonctionnel 50 existant entre les portions complémentaires 1A, 2A formant le canal de circulation 10A. Autrement dit, le jeu fonctionnel 50 est un espace entre la première partie 1A et la deuxième partie 2A subsistant entre les parois respectives desdites première et deuxième parties 1A, 2A après leur imbrication l'une dans l'autre.

Or, même si un joint est prévu pour être pris en sandwich entre des bords plats desdites portions complémentaires en contact plan-plan sur une portion périphérique correspondant à ces bords, le jeu fonctionnel destiné à permettre l'emboîtement des portions complémentaires est exploité par le fluide de refroidissement dont une part quitte le canal de circulation « tridimensionnel » du circuit de refroidissement pour s'immiscer dans le jeu fonctionnel permettant l'emboîtement des parties complémentaires.

Ce fluide de refroidissement qui s'immisce dans ledit jeu fonctionnel induit des pertes de charge et des pertes d'efficacité du refroidissement.

La présente invention vise à réduire ces pertes de charge et ces pertes thermiques, notamment dans le contexte d'un équipement électrique comprenant deux parties complémentaires comportant chacune une portion de circuit de refroidissement, formant, une fois assemblées, un canal de circulation « tridimensionnel » de circuit de refroidissement, un jeu fonctionnel étant prévu entre lesdites portions complémentaires pour permettre leur emboîtement et la formation dudit canal de circulation.

A cette fin, la présente invention prévoit la mise en place de déflecteurs, dans le canal de circulation, pour empêcher le fluide de refroidissement de s'introduire dans le jeu fonctionnel.

US2019/0045661 A1 divulgue un appareil pour encapsuler un circuit électronique qui est refroidi par un liquide de refroidissement.

### PRESENTATION DE L'INVENTION

Plus précisément, la présente invention vise un circuit de refroidissement, notamment pour un boîtier d'un équipement électrique, comprenant une première portion et une deuxième portion, lesdites première et deuxième portions du circuit de refroidissement étant complémentaires et comprenant respectivement des parties creuses et des parties en saillie configurées pour s'emboîter l'une dans l'autre de manière à former par assemblage un canal de circulation d'un fluide de refroidissement, ledit canal de circulation étant configuré pour générer un flux de fluide de refroidissement s'étendant sur des paliers différents agencés successivement l'un après l'autre le long dudit canal de circulation,
lesdites parties creuses et lesdites parties en saillie étant configurées pour s'emboîter l'une dans l'autre grâce à un jeu fonctionnel permettant l'imbrication desdites parties creuses et desdites parties en saillie, l'une au moins desdites première et deuxième portions de circuit complémentaires comprenant au moins un déflecteur configuré pour détourner le fluide de refroidissement dudit jeu fonctionnel.

Grâce à l'invention, la quantité de fluide de refroidissement susceptible de s'immiscer dans ledit jeu fonctionnel en dehors du canal de refroidissement est ainsi réduite.

Selon un mode de réalisation, ledit au moins un déflecteur comprend une nervure faisant saillie dans l'une au moins desdites première et deuxième portions de circuit complémentaires.

Selon un mode de réalisation, ledit au moins un déflecteur comprend une rainure creusée dans l'une au moins desdites première et deuxième portions de circuit complémentaires.

Selon un mode de réalisation, ledit au moins un déflecteur comprend une nervure et une rainure respectivement aménagées sur l'une et l'autre desdites première et deuxième portions de circuit de refroidissement, ladite nervure et ladite rainure étant configurées pour que la nervure s'engage dans ladite rainure lors de l'emboîtement desdites première et deuxième portions de circuit de refroidissement.

Avantageusement, le canal de circulation de fluide de refroidissement présente une section transversale sensiblement constante.

Selon un mode de réalisation, le circuit de refroidissement présente un plan moyen comprenant au moins une ligne de contact entre les première et deuxième portions de circuit de refroidissement, ledit canal de circulation comprenant au moins un tronçon formant un décrochage, dans une direction non parallèle audit plan moyen, et ledit tronçon s'étendant entre deux paliers successifs dudit canal de circulation.

Selon un mode de réalisation, ledit au moins un déflecteur est aménagé en amont ou en aval dudit au moins un décrochage et s'étend dans une direction orthogonale au sens de circulation du fluide de refroidissement.

Selon un mode de réalisation, le circuit de refroidissement comprend une paire de déflecteurs, en vis-à-vis, disposés de part et d'autre du canal de circulation, en amont ou en aval dudit au moins un décrochage.

Selon un mode de réalisation, lesdites première et deuxième portions de circuit de refroidissement comprennent respectivement une bordure plane appartenant au plan moyen, lesdites première et deuxième portions de circuit de refroidissement étant en contact plan - plan suivant leur bordure plane.

Selon un mode de réalisation, le canal de circulation de fluide de refroidissement comprend par ailleurs au moins une nervure de guidage, de préférence au moins deux nervures de guidage parallèles, aménagée sur au moins un tronçon d'au moins l'une desdites première et deuxième portions de circuit complémentaires, dans le sens de circulation du fluide de refroidissement, pour participer au guidage du fluide de refroidissement dans le canal de circulation.

L'invention vise aussi un boîtier pour un équipement électrique, ledit boîtier comprenant un circuit de refroidissement tel que brièvement décrit ci-dessus, dans lequel une première partie de boîtier comprend la première portion de circuit de refroidissement et une deuxième partie de boîtier comprend la deuxième portion de circuit de refroidissement,
ladite première partie de boîtier comprenant un logement configuré pour recevoir des composants électroniques dudit équipement électrique, ledit logement étant opposé à la première portion du circuit de refroidissement,
et la deuxième partie de boîtier formant un couvercle configuré pour venir sur une face du boîtier opposée audit logement de manière à former ledit circuit de refroidissement.

L'invention vise également un équipement électrique comprenant un boîtier tel que brièvement décrit ci-dessus et des composants électroniques disposés dans ledit logement du boîtier à des distances différentes d'un plan comprenant une ligne de contact entre les première et deuxième parties de boîtier, équipement électrique dans lequel le canal de circulation est configuré pour acheminer du fluide de refroidissement à proximité desdits composants électroniques de manière à les refroidir.

Selon un mode de réalisation, ledit équipement électrique forme un convertisseur de tension continu-continu, et/ou un onduleur et/ou un chargeur électrique, pour véhicule électrique ou hybride.

### PRESENTATION DES FIGURES

L'invention sera mieux comprise à la lecture de la description qui va suivre, donnée uniquement à titre d'exemple, et se référant aux dessins annexés donnés à titre d'exemples non limitatifs, dans lesquels des références identiques sont données à des objets semblables et sur lesquels :
Fig. 1 : la figure 1 (déjà commentée) montre une vue en coupe d'un canal de circulation dans un circuit de refroidissement de l'état de l'art, avec un jeu fonctionnel autorisant le passage de fluide de refroidissement ;
Fig. 2 : la figure 2 montre une vue en coupe, de côté, d'un circuit de refroidissement formé de deux portions complémentaires ;
Fig. 3 : la figure 3 est une vue éclatée d'un circuit de refroidissement d'équipement électrique selon l'invention, avec une première partie formant un châssis et une deuxième partie formant un couvercle ;
Fig. 4A : la figure 4A est une représentation schématique d'un exemple de première portion de circuit de refroidissement, montrant des nervures de déflecteurs ;
Fig. 4B : la figure 4B représente le même exemple de première portion de circuit de refroidissement qu'à la figure 4A, vue par la face opposée ;
Fig. 5 : la figure 5 est une représentation schématique zoomée sur une portion de canal tridimensionnel du circuit de refroidissement ;
Fig. 6 : la figure 6 est une représentation schématique montrant des nervures de guidage dans le canal tridimensionnel du circuit de refroidissement ;
Fig. 7 : la figure 7 est une représentation schématique d'un exemple de la deuxième partie de circuit de refroidissement, formant un couvercle de l'équipement électrique, montrant des rainures de déflecteurs, notamment complémentaires des nervures visibles sur la figure 4A.

Il faut noter que les figures exposent l'invention de manière détaillée pour mettre en oeuvre l'invention, lesdites figures pouvant bien entendu servir à mieux définir l'invention le cas échéant.

### DESCRIPTION DETAILLEE DE L'INVENTION

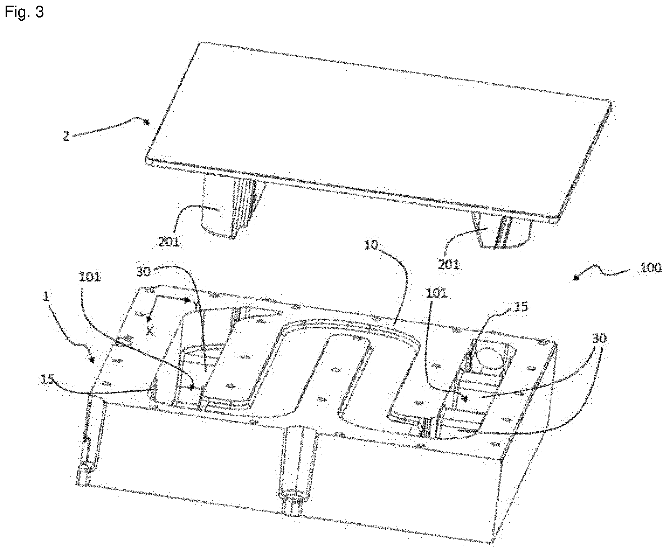

La figure 3 montre une vue éclatée d'un circuit de refroidissement 100 pouvant être intégré dans un boîtier d'équipement électrique, dans un exemple de réalisation, non limitatif, de l'invention.

Le circuit de refroidissement 100 comprend une première portion de circuit de refroidissement 10, notamment appartenant à une première partie de boîtier 1 formant une partie d'un châssis d'un équipement électrique, et une deuxième portion de circuit de refroidissement 20, notamment appartenant à une deuxième partie de boîtier 2 formant une fermeture pour ledit châssis d'équipement électrique.

Les première et deuxième portions de circuit de refroidissement 10, 20 forment, une fois assemblées, un circuit de refroidissement à fluide destiné à permettre la circulation d'un fluide de refroidissement, notamment un liquide de refroidissement, par exemple de l'eau et/ou du glycol, dans un canal de circulation « tridimensionnel » formé par lesdites portions de circuit de refroidissement 10, 20. Le canal de circulation « tridimensionnel » présente, une fois formée, une section de préférence constante, afin de minimiser les pertes de charge, et s'étend dans des directions non coplanaires, en ce sens que le fluide de refroidissement appelé à circuler dans ledit canal de circulation « tridimensionnel » subit des changements de direction non coplanaires ; ainsi, la direction moyenne du fluide de refroidissement subit des changement non coplanaires. Le canal de circulation présente ainsi des paliers différents agencés successivement l'un après l'autre le long dudit canal de circulation. Autrement dit, le canal de circulation est configuré de telle sorte qu'un fluide de refroidissement circulant dans ledit canal subit un changement de direction pour passer d'un palier à l'autre.

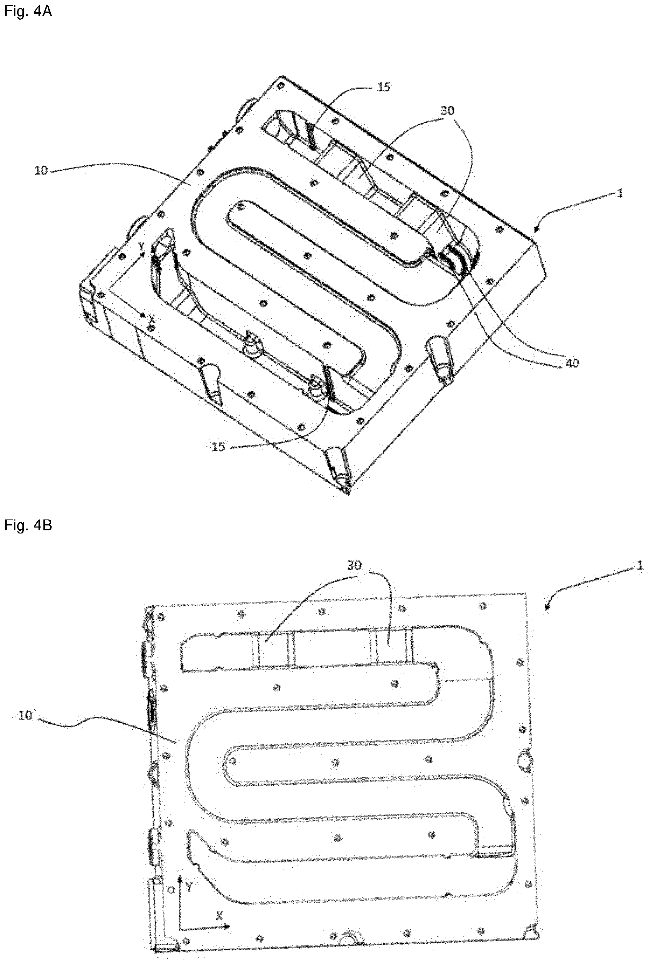

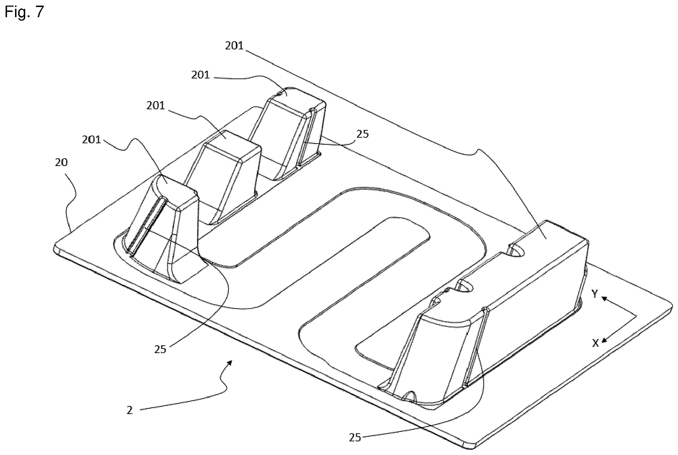

En particulier, dans un exemple de réalisation, la première portion de circuit 10, aménagée sur la première portion de circuit de refroidissement 10, représentée sur la figure 4A, comprend des parties creuses 101 et la deuxième portion de circuit 20, aménagée sur la deuxième portion de circuit de refroidissement 20, représentée sur la figure 7, comprend des parties faisant saillie 201.

Les parties creuses 101 et en saillie 201 aménagées respectivement sur la première 10 et sur la deuxième 20 portions de circuit de refroidissement sont complémentaires et configurées pour s'emboîter et pour former, ensemble, un circuit de refroidissement à fluide permettant la circulation d'un fluide de refroidissement. Comme expliqué précédemment, un jeu fonctionnel 50 est nécessaire pour permettre aux première 10 et deuxième 20 portions de circuit de refroidissement de s'emboîter l'une dans l'autre.

Le circuit de refroidissement ainsi formé est un canal de circulation « tridimensionnel », c'est-à-dire qu'il s'étend dans des directions non coplanaires. Autrement dit, le fluide de refroidissement qui circule dans le circuit de refroidissement ainsi formé subit des changements de direction non coplanaires.

Le circuit de refroidissement comprend ainsi des décrochages 30, correspondant à des tronçons du circuit de refroidissement sur lesquelles le fluide de refroidissement qui circule dans ledit circuit de refroidissement subit un changement de direction dans une direction sécante d'un plan moyen XY correspondant à un plan d'interface entre la première 10 et la deuxième 20 portions de circuit de refroidissement.

L'interface entre lesdites première 10 et deuxième 20 portions de circuit de refroidissement 100 comprend par exemple une bordure périphérique plane respective desdites première 10 et deuxième 20 portions de boîtier. Un plan moyen XY peut être défini comme le plan comprenant une telle interface ; il s'agit, autrement dit, d'un plan moyen XY dans lequel est établie au moins une ligne de contact entre lesdites première 10 et deuxième 20 parties de circuit de refroidissement 100. Un joint périphérique peut être prévu entre les première 10 deuxième 20 portions de circuit de refroidissement 100 ; ledit joint périphérique est alors disposé dans le plan moyen XY. Ledit joint périphérique est alors disposé entre les bordures périphériques planes respectives desdites première 10 et deuxième 20 portions de circuit de refroidissement 100.

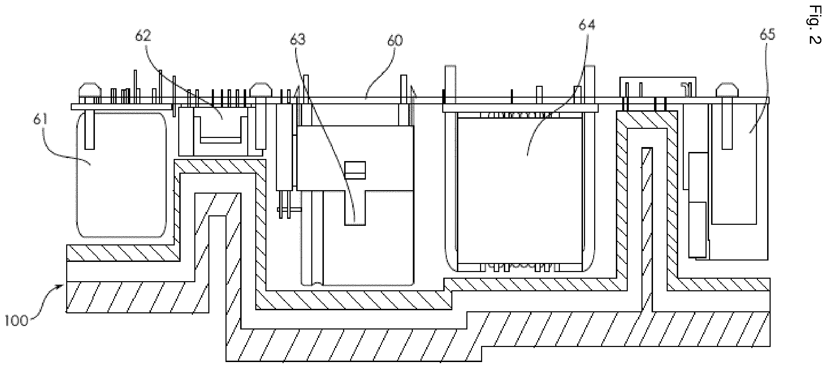

En référence à la figure 2, le caractère « tridimensionnel » du canal de circulation permet, en particulier, d'amener le fluide de refroidissement au plus près de composants électroniques 61, 62, 63, 64, 65 disposés dans un châssis. Dans un équipement électrique, notamment dans un chargeur électrique pour véhicule, les composants électroniques ne sont en effet pas nécessairement tous disposés sur un même pallier par rapport au plan moyen tel que défini ci-dessus. Par exemple, lesdits composants électroniques peuvent ne pas être disposés sur une même carte support. Ou alors, comme sur la figure 2, lesdits composants électroniques 61, 62, 63, 64, 65 peuvent être montés sur une même carte support 60 mais ne présentent pas les mêmes dimensions, ce qui implique que leur distance au plan médian XY est variable.

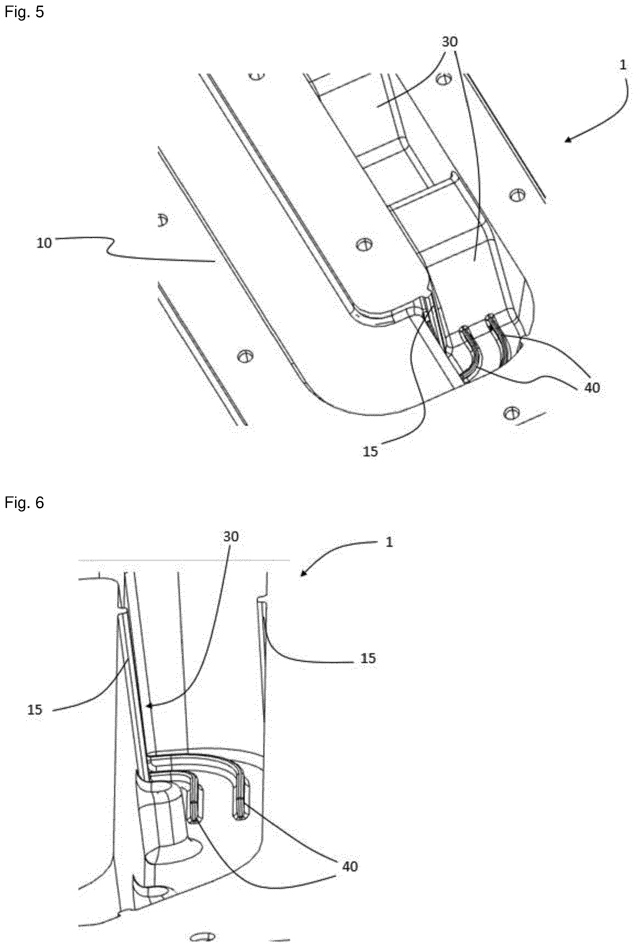

Ainsi, lesdits composants électroniques 61, 62, 63, 64, 65 ne se trouvent donc pas nécessairement tous dans un même plan. Grâce à un canal de circulation « tridimensionnel », autrement dit présentant plusieurs paliers successifs, tel que décrit ci-dessus en regard des figures 2, 3, 4A, 4B, 5, 6 et 7, on amène le fluide de refroidissement, dans le châssis, à différents paliers, autrement dit à différentes altitudes par rapport au plan moyen XY, de façon à ce que le fluide de refroidissement puisse se trouver au plus près de chaque composant électrique nécessitant d'être refroidi. L'efficacité du circuit de refroidissement est ainsi améliorée.

Pour éviter qu'une part du fluide de refroidissement ne s'immisce dans le jeu fonctionnel 50, les première 10 et deuxième 20 portions de circuit de refroidissement complémentaires comprennent des déflecteurs aménagés principalement sur des tronçons identifiés comme « stratégiques » du canal de circulation « tridimensionnel ».

En particulier, les déflecteurs sont formés par des rainures 25 et des nervures 15, lesdites nervures 15 et lesdites rainures 25 étant complémentaires, en ce sens que l'une des première 1 et deuxième 2 parties de boîter comprend au moins une nervure 15 qui s'engage dans au moins une rainure 25 correspondante aménagée dans l'autre partie de circuit de refroidissement. Notamment, ladite nervure 40 de guidage s'étend dans un palier du canal de circulation.

Selon un mode de réalisation, il peut n'y avoir que des nervures 15, même si l'efficacité peut s'en trouver réduite.

Les déflecteurs ainsi formés sont configurés pour dévier le flux de fluide de refroidissement de sorte à éviter qu'il ne s'immisce dans le jeu fonctionnel 50.

De préférence, les déflecteurs 15, 25 sont prévus sur des tronçons du canal de circulation « tridimensionnel » situées en amont de tronçons sur lesquels un changement de direction brutal existe. Selon un mode de réalisation préféré, des déflecteurs sont prévus en amont de décrochages 30 importants existant dans le canal tridimensionnel. Par exemple, des déflecteurs sont prévus lorsqu'un décrochage 30 à environ 90° et d'une hauteur supérieure à la moitié de la largeur du canal existe dans le canal tridimensionnel, ladite hauteur étant supérieure à la hauteur de la section du canal en amont dudit décrochage 30. Dans ce cas, un déflecteur est notamment disposé en amont dudit décrochage 30.

Selon un mode de réalisation, deux déflecteurs sont prévus de part et d'autre du canal tridimensionnel, en amont de chaque décrochage 30, lesdits déflecteurs s'étendant selon une direction parallèle au décrochage 30 correspondant. En particulier, le circuit de refroidissement peut comprendre une pluralité de déflecteurs comprenant au moins une nervure 15 faisant saillie dans l'une au moins desdites première 10 et deuxième 20 portions de circuit complémentaires et au moins une rainure 25 creusée dans l'une au moins desdites première 10 et deuxième 20 portions de circuit complémentaires, de façon correspondante.

Chaque décrochage 30 comprend alors une nervure 15. De préférence, chaque déflecteur est composé d'une nervure 15, aménagée sur l'une ou l'autres des première 10 et deuxième 20 portions de circuit de refroidissement et, sur l'autre desdites première 10 et deuxième 20 portions de circuit de refroidissement, une rainure 25 dans laquelle s'engage la nervure 15 correspondante lorsque les première 10 et deuxième 20 portions de circuit de refroidissement 100 sont assemblées.

Dans ce dernier cas, un avantage supplémentaire réside dans le fait que l'engagement de chaque nervure 15 dans une rainure 25 participe au guidage des première 10 et deuxième 20 portions l'une par rapport à l'autre lors de leur emboîtement, voire participe à la rigidification du circuit de refroidissement 100 ainsi obtenu.

Le canal de circulation peut par ailleurs comprendre, sur des tronçons, notamment des tronçons tournants, des nervures de guidage 40 pour guider le fluide de refroidissement dans le canal de circulation. Les nervures de guidage 40 ont par exemple une hauteur comprise entre 2 mm et 3 mm.

Selon une mise en oeuvre préférée, le circuit de refroidissement 100 selon l'invention est intégré dans un boîtier pour un équipement électrique. Le boîtier comprend une première partie de boîtier 1 comprenant la première portion de circuit de refroidissement 10 et une deuxième partie de boîtier 2 comprenant la deuxième portion de circuit de refroidissement 20.

Dans ce cas, ladite première partie de boîtier 1 comprend un logement configuré pour recevoir des composants électroniques 61, 62, 63, 64, 65 dudit équipement électrique, ledit logement étant opposé à la première portion du circuit de refroidissement 10 et la deuxième partie de boîtier 2 forme un couvercle configuré pour venir sur une face du boîtier opposée audit logement de manière à former ledit circuit de refroidissement 100. La deuxième partie de boîtier 2 peut comprendre également un logement configuré pour recevoir des composants électroniques dudit équipement électrique, ledit logement étant opposé à la deuxième portion du circuit de refroidissement 20.

Autrement dit, la première 1 et la deuxième 2 parties s'emboîtent l'une dans l'autre, par exemple un châssis 1 et un couvercle 2 d'un équipement électrique s'emboîtent l'un dans l'autre, de sorte que des première et deuxième portions 10, 20 de circuit de refroidissement aménagées respectivement dans l'une et l'autre desdites première 1 et deuxième 2 parties de circuit de refroidissement forment, par assemblage, le canal de circulation. Le plan moyen XY est alors typiquement parallèle à un plan dans lequel s'étend le couvercle 2 et orthogonal à une paroi latérale du châssis 1.

## Revendications

1. Circuit de refroidissement (100), notamment pour un boîtier d'un équipement électrique, comprenant une première portion (10) et une deuxième portion (20), lesdites première et deuxième portions (10, 20) du circuit de refroidissement étant complémentaires et comprenant respectivement des parties creuses (101) et des parties en saillie (201) configurées pour s'emboîter l'une dans l'autre de manière à former par assemblage un canal de circulation d'un fluide de refroidissement, ledit canal de circulation étant configuré pour générer un flux de fluide de refroidissement s'étendant sur des paliers différents agencés successivement l'un après l'autre le long dudit canal de circulation, **caractérisé par**
lesdites parties creuses (101) et lesdites parties en saillie (201) étant configurées pour s'emboîter l'une dans l'autre grâce à un jeu fonctionnel (50) permettant l'imbrication desdites parties creuses (101) et desdites parties en saillie (201), l'une au moins desdites première (10) et deuxième (20) portions de circuit complémentaires comprenant au moins un déflecteur (15, 25) configuré pour détourner le fluide de refroidissement dudit jeu fonctionnel (50).

2. Circuit de refroidissement selon la revendication précédente, dans lequel ledit au moins un déflecteur comprend une nervure (15) faisant saillie dans l'une au moins desdites première (10) et deuxième (20) portions de circuit complémentaires.

3. Circuit de refroidissement selon l'une des revendications précédentes, dans lequel ledit au moins un déflecteur comprend une rainure (25) creusée dans l'une au moins desdites première (10) et deuxième (20) portions de circuit complémentaires.

4. Circuit de refroidissement selon l'une des revendications précédentes, dans lequel ledit au moins un déflecteur comprend une nervure (15) et une rainure (25) respectivement aménagées sur l'une et l'autre desdites première (10) et deuxième (20) portions de circuit de refroidissement, ladite nervure (15) et ladite rainure (25) étant configurées pour que la nervure (15) s'engage dans ladite rainure (25) lors de l'emboîtement desdites première (10) et deuxième (20) portions de circuit de refroidissement.

5. Circuit de refroidissement selon l'une des revendications précédentes, dans lequel le canal de circulation de fluide de refroidissement présente une section transversale sensiblement constante.

6. Circuit de refroidissement selon l'une des revendications précédentes, présentant un plan moyen (XY) comprenant au moins une ligne de contact entre les première (10) et deuxième (20) portions de circuit de refroidissement, ledit canal de circulation comprenant au moins un tronçon formant un décrochage (30), dans une direction non parallèle audit plan moyen (XY), et ledit tronçon s'étendant entre deux paliers successifs dudit canal de circulation.

7. Circuit de refroidissement selon la revendication précédente, dans lequel ledit au moins un déflecteur (15, 25) est aménagé en amont ou en aval dudit au moins un décrochage (30) et s'étend dans une direction orthogonale au sens de circulation du fluide de refroidissement.

8. Circuit de refroidissement selon la revendication 6 ou 7, comprenant une paire de déflecteurs (15, 25), en vis-à-vis, disposés de part et d'autre du canal de circulation, en amont ou en aval dudit au moins un décrochage (30).

9. Circuit de refroidissement selon l'une des revendications 6 à 8, dans lequel lesdites première (10) et deuxième (20) portions de circuit de refroidissement comprennent respectivement une bordure plane appartenant au plan moyen, lesdites première (10) et deuxième (20) portions de circuit de refroidissement étant en contact plan - plan suivant leur bordure plane.

10. Circuit de refroidissement selon l'une des revendications précédentes, dans lequel le canal de circulation de fluide de refroidissement comprend par ailleurs au moins une nervure de guidage (40), de préférence au moins deux nervures de guidage (40) parallèles, aménagée sur au moins un tronçon d'au moins l'une desdites première (10) et deuxième (20) portions de circuit complémentaires, dans le sens de circulation du fluide de refroidissement, pour participer au guidage du fluide de refroidissement dans le canal de circulation.

11. Boîtier pour un équipement électrique, ledit boîtier comprenant un circuit de refroidissement (100) selon l'une des revendications précédentes, dans lequel une première partie de boîtier (1) comprend la première portion (10) de circuit de refroidissement et une deuxième partie de boîtier (2) comprend la deuxième portion (20) de circuit de refroidissement,
ladite première partie de boîtier comprenant un logement configuré pour recevoir des composants électroniques dudit équipement électrique, ledit logement étant opposé à la première portion du circuit de refroidissement,
et la deuxième partie de boîtier (2) formant un couvercle configuré pour venir sur une face du boîtier opposée audit logement de manière à former ledit circuit de refroidissement.

12. Equipement électrique comprenant un boîtier selon la revendication précédente et des composants électroniques disposés dans ledit logement du boîtier à des distances différentes d'un plan comprenant une ligne de contact entre les première (10) et deuxième (20) portions de circuit de refroidissement (100), équipement électrique dans lequel le canal de circulation est configuré pour acheminer du fluide de refroidissement à proximité desdits composants électroniques (61, 62, 63, 64, 65) de manière à les refroidir.

13. Equipement électrique selon la revendication précédente, formant un convertisseur de tension continu-continu, et/ou un onduleur et/ou un chargeur électrique, pour véhicule électrique ou hybride.

## Patentansprüche

1. Kühlkreislauf (100), insbesondere für ein Gehäuse eines elektrischen Geräts, umfassend ein erstes Teilstück (10) und ein zweites Teilstück (20), wobei die ersten und zweiten Teilstücke (10, 20) des Kühlkreislaufs komplementär sind und jeweils hohle Teile (101) und vorspringende Teile (201) umfassen, die dazu ausgestaltet sind, ineinandergesteckt zu werden, so dass sie durch Fügen einen Zirkulationskanal für ein Kühlfluid bilden, wobei der Zirkulationskanal dazu ausgestaltet ist, einen Kühlfluidstrom zu erzeugen, der sich über verschiedene Stufen erstreckt, die hintereinander entlang des Zirkulationskanals angeordnet sind, **gekennzeichnet durch** die hohlen Teile (101) und die vorspringenden Teile (201), die dazu ausgestaltet sind, ineinandergesteckt zu werden dank eines funktionalen Spiels (50), welches das Ineinandergreifen der hohlen Teile (101) und der vorspringenden Teile (201) ermöglicht, wobei mindestens eines der ersten (10) und zweiten (20) komplementären Kreislaufteilstücke mindestens einen Deflektor (15, 25) umfasst, der dazu ausgestaltet ist, das Kühlfluid des funktionalen Spiels (50) abzulenken.

2. Kühlkreislauf nach dem vorhergehenden Anspruch, bei dem der mindestens eine Deflektor eine Rippe (15) umfasst, die in mindestens einem der ersten (10) und zweiten (20) komplementären Kreislaufteilstücke vorspringt.

3. Kühlkreislauf nach einem der vorhergehenden Ansprüche, bei dem der mindestens eine Deflektor eine Nut (25) umfasst, die in mindestens einem der ersten (10) und zweiten (20) komplementären Kreislaufteilstücke ausgearbeitet ist.

4. Kühlkreislauf nach einem der vorhergehenden Ansprüche, bei dem der mindestens eine Deflektor eine Rippe (15) und eine Nut (25) umfasst, die jeweils an dem einen und dem anderen der ersten (10) und zweiten (20) Kühlkreislaufteilstücke ausgebildet sind, wobei die Rippe (15) und die Nut (25) dazu ausgestaltet sind, dass die Rippe (15) beim Zusammenstecken der ersten (10) und zweiten (20) Kühlkreislaufteilstücke in die Nut (25) eingeführt wird.

5. Kühlkreislauf nach einem der vorhergehenden Ansprüche, bei dem der Kühlfluidzirkulationskanal einen im Wesentlichen konstanten Querschnitt aufweist.

6. Kühlkreislauf nach einem der vorhergehenden Ansprüche, aufweisend eine Mittelebene (XY), die mindestens eine Kontaktlinie zwischen den ersten (10) und zweiten (20) Kühlkreislaufteilstücken umfasst, wobei der Zirkulationskanal mindestens ein Abschnitt umfasst, der einen Rücksprung (30) in eine zu der Mittelebene (XY) nicht parallele Richtung bildet, und wobei sich der Abschnitt zwischen zwei aufeinander folgenden Stufen des Zirkulationskanals erstreckt.

7. Kühlkreislauf nach dem vorhergehenden Anspruch, bei dem der mindestens eine Deflektor (15, 25) stromauf oder stromab des mindestens einen Rücksprungs (30) ausgebildet ist und sich in eine senkrecht zur Zirkulationsrichtung des Kühlfluids verlaufende Richtung erstreckt.

8. Kühlkreislauf nach Anspruch 6 oder 7, umfassend ein Paar gegenüberliegende Deflektoren (15, 25), die beidseits des Zirkulationskanals stromauf oder stromab des mindestens einen Rücksprungs (30) angeordnet sind.

9. Kühlkreislauf nach einem der Ansprüche 6 bis 8, bei dem die ersten (10) und zweiten (20) Kühlkreislaufteilstücke jeweils einen flachen Rand umfassen, der zur Mittelebene gehört, wobei die ersten (10) und zweiten (20) Kühlkreislaufteilstücke entlang ihres flachen Randes in Flach-auf-flach-Kontakt sind.

10. Kühlkreislauf nach einem der vorhergehenden Ansprüche, bei dem der Kühlfluidzirkulationskanal im Übrigen mindestens eine Führungsrippe (40) umfasst, bevorzugt mindestens zwei parallele Führungsrippen (40), die an mindestens einem Abschnitt mindestens eines der ersten (10) und zweiten (20) komplementären Kreislaufteilstücke, in Zirkulationsrichtung des Kühlfluids, ausgebildet sind, um zum Führen des Kühlfluids in dem Zirkulationskanal beizutragen.

11. Gehäuse für ein elektrisches Gerät, wobei das Gehäuse einen Kühlkreislauf (100) nach einem der vorhergehenden Ansprüche umfasst, bei dem ein erstes Gehäuseteil (1) das erste Kühlkreislaufteilstück (10) umfasst und ein zweites Gehäuseteil (2) das zweite Kühlkreislaufteilstück (20) umfasst, wobei das erste Gehäuseteil eine Aufnahme umfasst, die dazu ausgestaltet ist, elektronische Bauelemente des elektrischen Geräts aufzunehmen, wobei die Aufnahme entgegengesetzt zu dem ersten Teilstück des Kühlkreislaufs ist, und wobei das zweite Gehäuseteil (2) einen Deckel bildet, der dazu ausgestaltet ist, auf eine zu der Aufnahme entgegengesetzte Seite des Gehäuses gesetzt zu werden, so dass der Kühlkreislauf gebildet wird.

12. Elektrisches Gerät, umfassend ein Gehäuse nach dem vorhergehenden Anspruch und elektronische Bauelemente, die in der Aufnahme des Gehäuses in unterschiedlichen Abständen von einer Ebene angeordnet sind, die eine Kontaktlinie zwischen den ersten (10) und zweiten (20) Teilstücken des Kühlkreislaufs (100) umfasst, wobei in dem elektrischen Gerät der Zirkulationskanal dazu ausgestaltet ist, Kühlfluid in der Nähe der elektronischen Bauelemente (61, 62, 63, 64, 65) zu befördern, so dass sie gekühlt werden.

13. Elektrisches Gerät nach dem vorhergehenden Anspruch, das einen Gleichspannungswandler und/oder einen Wechselrichter und/oder ein elektrisches Ladegerät für ein Elektro- oder Hybridfahrzeug bildet.

## Claims

1. Cooling circuit (100), in particular for a casing for electrical equipment, comprising a first portion (10) and a second portion (20), said first and second portions (10, 20) of the cooling circuit being complementary and respectively comprising recessed parts (101) and protruding parts (201) that are configured to fit into one another so as to form a circulation channel for a cooling fluid when assembled, said circulation channel being configured to generate a flow of cooling fluid extending over various levels successively arranged one after the other along said circulation channel, **characterized by**
said recessed parts (101) and said protruding parts (201) being configured to fit into one another by virtue of a functional clearance (50) that allows said recessed parts (101) and said protruding parts (201) to interlock, at least one of said first (10) and second (20) complementary circuit portions comprising at least one deflector (15, 25) configured to divert the cooling fluid away from said functional clearance (50).

2. Cooling circuit according to the preceding claim, wherein said at least one deflector comprises a rib (15) protruding into at least one of said first (10) and second (20) complementary circuit portions.

3. Cooling circuit according to either of the preceding claims, wherein said at least one deflector comprises a groove (25) recessed into at least one of said first (10) and second (20) complementary circuit portions.

4. Cooling circuit according to one of the preceding claims, wherein said at least one deflector comprises a rib (15) and a groove (25), which are respectively arranged on each of said first (10) and second (20) cooling circuit portions, said rib (15) and said groove (25) being configured so that the rib (15) engages in said groove (25) when said first (10) and second (20) cooling circuit portions are interlocking.

5. Cooling circuit according to one of the preceding claims, wherein the cooling fluid circulation channel has a substantially constant cross section.

6. Cooling circuit according to one of the preceding claims, having a median plane (XY) comprising at least one line of contact between the first (10) and second (20) cooling circuit portions, said circulation channel comprising at least one section forming a step (30), in a direction that is not parallel to said median plane (XY), and said section extending between two successive levels of said circulation channel.

7. Cooling circuit according to the preceding claim, wherein said at least one deflector (15, 25) is arranged upstream or downstream of said at least one step (30) and extends in a direction that is orthogonal to the direction of circulation of the cooling fluid.

8. Cooling circuit according to Claim 6 or 7, comprising a pair of deflectors (15, 25), which face one another and are arranged on either side of the circulation channel, upstream or downstream of said at least one step (30).

9. Cooling circuit according to one of Claims 6 to 8, wherein said first (10) and second (20) cooling circuit portions respectively comprise a planar edge that is part of the median plane, said first (10) and second (20) cooling circuit portions being in plane-to-plane contact along the planar edge thereof.

10. Cooling circuit according to one of the preceding claims, wherein the cooling fluid circulation channel furthermore comprises at least one guide rib (40), preferably at least two parallel guide ribs (40), arranged on at least one section of at least one of said first (10) and second (20) complementary circuit portions, in the direction of circulation of the cooling fluid, in order to assist in guiding the cooling fluid in the circulation channel.

11. Casing for electrical equipment, said casing comprising a cooling circuit (100) according to one of the preceding claims, wherein a first casing part (1) comprises the first cooling circuit portion (10) and a second casing part (2) comprises the second cooling circuit portion (20), said first casing part comprising a housing configured to receive electronic components of said electrical equipment, said housing being opposite the first portion of the cooling circuit,
and the second casing part (2) forming a cover that is configured to go over a face of the casing that is opposite said housing so as to form said cooling circuit.

12. Electrical equipment comprising a casing according to the preceding claim and electronic components arranged in said housing of the casing at various distances from a plane comprising a line of contact between the first (10) and second (20) portions of the cooling circuit (100), in which electrical equipment the circulation channel is configured to convey cooling fluid in the vicinity of said electronic components (61, 62, 63, 64, 65) so as to cool them.

13. Electrical equipment according to the preceding claim, forming a DC-to-DC voltage converter and/or an inverter and/or an electrical charger, for an electric or hybrid vehicle.
